# FASCICULE DE BREVET EUROPEEN

(11) **EP 3 715 123 B1**
(45) Date de publication et mention de la délivrance du brevet: **26.01.2022**
(21) Numéro de dépôt: 20164073.7
(22) Date de dépôt: 19.03.2020
(51) Int. Cl.: B41F 15/08, B41F 15/36, B41F 15/46, H01L 31/18, H05K 3/12

(54) **DISPOSITIF DE RACLAGE POUR LA RÉALISATION DES LIGNES CONDUCTRICES D'UNE CELLULE PHOTOVOLTAÏQUE**
RAKELVORRICHTUNG FÜR DIE ERZEUGUNG VON LEITERBAHNEN IN EINER FOTOVOLTAIKZELLE
SQUEEGEE DEVICE FOR PRODUCING CONDUCTIVE LINES OF A PHOTOVOLTAIC CELL

(30) Priorité: 25.03.2019 FR 1903062
(43) Date de publication de la demande: 30.09.2020
(73) Titulaire: Commissariat à l'énergie atomique et aux énergies alternatives, 75015 Paris (FR)
(72) Inventeur: REY, Nicolas, 38054 Grenoble Cedex 09 (FR); JERONIMO, Pedro, 38054 Grenoble Cedex 09 (FR)
(74) Mandataire: INNOV-GROUP

(56) Documents cités:
- WO-A1-2014/080010
- US-A1- 2016 200 096
- US-B1- 6 494 132

## Description

### Domaine technique de l'invention

L'invention se situe dans le domaine de la fabrication des cellules photovoltaïques, plus précisément dans la réalisation des lignes (ou électrodes) conductrices parallèles réalisées par sérigraphie sur la surface d'un support, en particulier un support à base de silicium ("wafer") d'une cellule photovoltaïque.

L'invention concerne ainsi un dispositif de raclage employé pour la réalisation des lignes par sérigraphie et un procédé de réalisation des lignes conductrices utilisant ledit dispositif de raclage.

### Etat de la technique

De manière connue, une cellule photovoltaïque comporte plusieurs lignes conductrices (appelées aussi électrodes ou "fingers" en anglais) parallèles interconnectées sur sa surface. La cellule peut être sans barre de bus ("busbarless" en anglais) ou doté de barres de bus ("busbars") parallèles réalisées perpendiculairement aux lignes conductrices parallèles évoquées ci-dessus.

De manière connue, ces lignes conductrices parallèles peuvent être réalisées par sérigraphie.

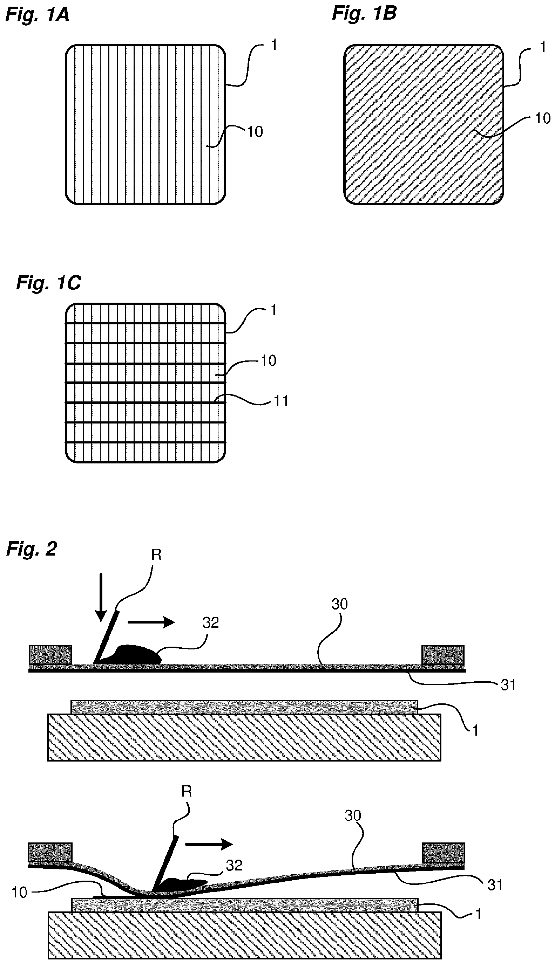

Comme on peut le voir sur la figure 2, la réalisation par sérigraphie consiste à transférer une encre conductrice à travers un écran sur un support ("wafer"). L'écran est constitué d'une toile à maillage ouvert qui est recouverte d'une émulsion délimitant le motif à sérigraphier. Pour réaliser le transfert, on applique une force suffisante sur une racle, commandée en translation suivant la direction d'impression des lignes. En un seul passage, la racle génère l'ensemble des lignes parallèles sur le support. Le raclage génère un cordon d'encre en aval de la racle. Un contre-raclage peut être opéré pour étaler de nouveau l'encre en vue du prochain transfert.

Une telle solution a notamment été décrite dans les demandes de brevets JP2010142990A et WO2014/091603A1**.**

D'autres solutions ont également été décrites dans les demandes de brevets US2016/200096A1, WO2014/080010A1 et dans le brevet US6494132B1.

Cependant, toutes ces solutions ne sont souvent pas satisfaisantes, notamment pour les raisons suivantes :
- Elles nécessitent une racle plus grande que la longueur standard, légèrement supérieure à la diagonale du support pour pouvoir couvrir tout le motif avec l'encre à sérigraphier ;
- Le contrôle de la pression exercée par la racle est moins précis du fait de sa plus grande longueur, pouvant occasionner des disparités d'impression entre les lignes conductrices présentes au milieu et les lignes conductrices situées le plus à l'extérieur ;
- Elles nécessitent l'emploi d'un écran beaucoup plus grand pour tenir compte de l'encombrement de la racle et de sa course ;
- L'écran étant d'une surface plus importante, celui-ci peut s'avérer plus fragile ;
- Elles présentent un coût plus important car la surface de l'écran employé est plus grande ;

Le but de l'invention est donc de proposer un dispositif de raclage permettant de résoudre les inconvénients listés ci-dessus.

### Exposé de l'invention

Ce but est atteint par un dispositif de raclage selon la revendication 1, à savoir un dispositif de raclage employé pour réaliser par sérigraphie des lignes conductrices parallèles sur un support à travers un masque, le dispositif de raclage comportant :
- N racles, avec N supérieur ou égal à 2, chaque racle étant définie par un rang i, avec i allant de 1 à N, les N racles étant disposées de manière adjacente et déplaçables en translation pour générer chacune de manière distincte une ou plusieurs desdites lignes parallèles,
- Des moyens de réglage en hauteur associés à chaque racle, ladite hauteur correspondant à la distance entre la racle et ledit support suivant une direction normale audit support à imprimer,
- Un système de commande du dispositif de raclage qui comporte, pour chaque racle de rang i, un module de commande indépendant configuré pour commander ses moyens de réglage en hauteur,
- Les N racles étant constituées d'une seule racle dite racle maître et de racles dite racles esclaves,
- Chaque module de commande étant configuré pour déterminer un signal de commande à destination desdits moyens de réglage en hauteur, ledit signal de commande étant généré à partir d'une boucle de régulation sur une valeur de consigne appliquée en entrée, et, pour chaque racle esclave, d'une valeur de contre-réaction provenant du module de commande dédiée à la commande d'au moins une autre racle.

Selon une première réalisation, le module de commande associé à chaque racle reçoit la valeur de contre-réaction provenant du module de commande associé à chaque racle qui est juxtaposée à sa racle.

Selon une deuxième réalisation, le module de commande associé à chaque racle de rang i, pour i allant de 2 à N, reçoit la valeur de contre-réaction provenant du module de commande de chaque racle de rang i-1.

Selon une troisième réalisation, le module de commande associé à chaque racle esclave reçoit la valeur de contre-réaction provenant du module de commande de la racle maître.

Selon une particularité, la valeur de consigne est une valeur de pression mécanique de raclage.

Selon une autre particularité, la valeur de consigne en pression est identique pour toutes les racles.

Selon une autre particularité, chaque valeur de contre-réaction est une hauteur de racle.

Selon une réalisation particulière, les moyens de réglage en hauteur associés à chaque racle sont tous montés sur un châssis commun.

Selon une particularité, le châssis comporte une glissière orientée suivant la direction de raclage à appliquer.

Selon une autre réalisation particulière, les moyens de réglage en hauteur associés à chaque racle sont tous montés sur un châssis indépendant par rapport à celui de chaque autre racle, chaque châssis indépendant comprenant une glissière indépendante pour guider la course de sa racle.

Selon une particularité, le dispositif comporte des moyens de réglage de l'orientation de chaque glissière pour adapter l'angle de raclage.

L'invention concerne également un procédé selon la revendication 12, à savoir un procédé de réalisation de lignes conductrices parallèles sur un support par sérigraphie à travers un masque, mis en œuvre à l'aide d'un dispositif de raclage tel que défini ci-dessus, dans lequel, pour chaque racle esclave du dispositif, il comporte les étapes suivantes :
- Détermination d'une valeur de commande à partir d'une valeur de consigne et d'une première valeur corrigée représentative d'une pression mesurée ou estimée de la racle esclave,
- Détermination de la hauteur de la racle esclave en fonction de ladite valeur de commande et d'une valeur de contre-réaction provenant du module de commande dédiée à la commande d'au moins une autre racle du dispositif.

Selon une particularité, le module de commande associé à chaque racle reçoit la valeur de contre-réaction provenant du module de commande associé à chaque racle qui est juxtaposée à sa racle.

Selon une autre particularité, le module de commande associé à chaque racle de rang i, pour i allant de 2 à N, reçoit la valeur de contre-réaction provenant du module de commande de chaque racle de rang i-1.

Selon une autre particularité, le module de commande associé à chaque racle esclave reçoit la valeur de contre-réaction provenant du module de commande de la racle maître.

L'invention concerne enfin l'utilisation selon la revendication 16 du dispositif de raclage mentionné ci-dessus, à savoir l'utilisation du dispositif de raclage ci-dessus pour réaliser des lignes conductrices parallèles sur un support d'une cellule photovoltaïque.

Contrairement aux équipements actuels avec une seule racle régulée (en pression ou en position), la complexité de cette invention, et à la fois son point clé, consiste à mettre en œuvre l'asservissement des racles tout en gérant leur interdépendance.

Le dispositif peut être adapté à une tête de sérigraphie classique et est compatible avec des écrans ayant un format de 355 mm × 355 mm, ou même plus grand pour certaines applications.

### Brève description des figures

D'autres caractéristiques et avantages vont apparaître dans la description détaillée qui suit, en liaison avec les figures listées ci-dessous :
- Les figures 1A, 1B et 1C montrent en vue de dessus différentes réalisations possibles de la sérigraphie d'une cellule photovoltaïque ;
- La figure 2 illustre le principe d'impression par sérigraphie à une seule racle, connu dans l'état de la technique ;
- Les figures 3A et 3B représentent de manière schématique le dispositif de raclage selon un mode de réalisation de l'invention et son système de commande, respectivement en vue de dessus et en vue de côté, employé pour la sérigraphie de lignes parallèles sur un support ;
- La figure 3C représente une variante de réalisation du dispositif de raclage
- La figure 4 permet d'illustrer le dimensionnement du dispositif de raclage selon un mode de réalisation de l'invention;
- La figure 5 illustre une variante de réalisation du dispositif de raclage
- Les figure 6A à 6C représentent plusieurs schémas de commande du dispositif de raclage selon un mode de réalisation de l'invention ;

### Description détaillée d'au moins un mode de réalisation

Pour la suite de la description, on définit la direction de raclage (X) qui correspond à la direction de translation rectiligne des racles du dispositif, cette direction étant parallèle à la direction des lignes conductrices 10 à réaliser sur le support 1. La hauteur d'une racle R_i est définie pour sa part par la distance entre la racle R_i et le support 1 (ou l'écran) suivant une direction normale audit support à imprimer.

L'invention vise un dispositif de raclage 2 pouvant être employé pour réaliser, par sérigraphie, des lignes conductrices L parallèles d'une cellule photovoltaïque.

Comme représenté sur les figures 1A à 1C, une cellule photovoltaïque peut comporter plusieurs lignes conductrices 10 interconnectées agencées en parallèle. Elles sont réalisées sur un support 1 notamment en silicium, appelé généralement "wafer". Sur ce support elles sont réalisées suivant une direction donnée. Comme représenté sur la figure 1A, sur un support de forme carrée ou pseudo-carrée, elles sont orientées suivant l'un ou l'autre des deux côtés. Sur la figure 1B, elles sont orientées à 45° suivant une diagonale du support. Sur la figure 1C, la cellule comporte également des barres de bus 11 ("busbars") parallèles qui sont plus épaisses et orientées perpendiculairement aux lignes conductrices 10.

Le dispositif de raclage 2 de l'invention sera adapté pour réaliser, sur un support, des lignes conductrices ou barres de bus parallèles, selon n'importe quelle orientation.

Le dispositif de raclage 2 est employé dans un procédé de fabrication par sérigraphie.

Pour rappel, en référence à la figure 2, la réalisation des lignes conductrices 10 par sérigraphie consiste à positionner un écran 30 (c'est-à-dire un masque) au-dessus du support 1 à sérigraphier. L'écran 30 est constitué d'une toile à maillage ouvert qui est recouverte d'une émulsion 31 délimitant le motif à sérigraphier. Le procédé consiste ensuite à déposer une encre 32 conductrice sur cet écran, à exercer une pression suffisante contre l'écran à l'aide d'une racle R pour plaquer l'écran contre le support 1, puis à déplacer la racle R suivant une direction rectiligne pour imprimer l'encre 32 sur le support 1 suivant le motif de lignes défini grâce à l'écran.

Comme évoqué plus haut, dans l'état de la technique, le dispositif de raclage ne comporte qu'une seule racle R pour imprimer l'ensemble des lignes sur le support. La seule et unique racle présente traditionnellement une longueur comprise entre 160 mm et 180 mm pour des supports carrés de 156 mm de côté.

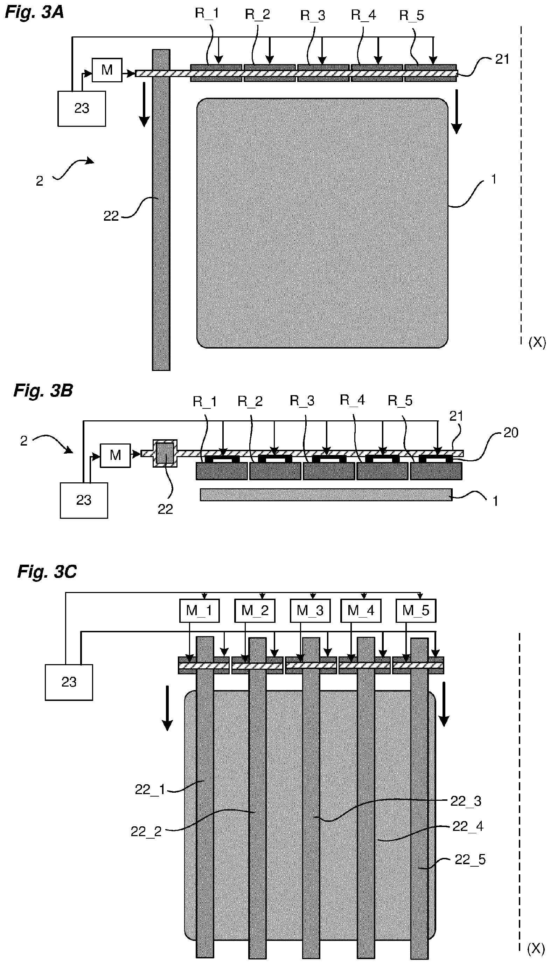

Selon l'invention, en référence aux figures 3A à 3C, le dispositif de raclage 2 comporte pour sa part plusieurs racles, référencées chacune R_i.

Pour la suite de la description, nous décrivons ainsi un dispositif de raclage qui comporte N racles R_i, N étant supérieur ou égal à 2. Les N racles sont toutes positionnées de manière adjacente sur la longueur du support, orientées perpendiculairement à la direction de raclage (X). Elles se déplacent toutes, avantageusement dans le même sens, suivant une même direction rectiligne (correspondant à la direction des lignes conductrices à réaliser). Dans la série de racles juxtaposées, chaque racle R_i est identifiée par un rang i, avec i allant de 1 à N. La racle de rang 1 et la racle de rang N sont celles qui sont situées le plus à l'extérieur.

De manière avantageuse, toutes les racles R_i sont identiques. On verra ci-après que chaque racle R_i peut être définie par sa longueur l_i, définie par la distance entre ses deux extrémités suivant une direction perpendiculaire à la direction de raclage et déterminant son étendue de raclage. Comme le dispositif utilise plusieurs racles adjacentes actionnées en parallèle et simultanément pour imprimer l'ensemble des lignes, on comprend que toutes les lignes à imprimer du support sont donc séparées en plusieurs ensembles distincts d'une ou plusieurs lignes et que chaque racle est destinée à réaliser un seul ensemble de lignes. Il s'agit donc de morceler la réalisation des lignes et de les réaliser par plusieurs racles au lieu d'une seule comme dans l'état de la technique.De manière avantageuse, toutes les racles R_i sont disposées sur une même ligne, qui est perpendiculaire à la direction (X) des lignes conductrices à réaliser sur le support. Dans une variante, les racles R_i peuvent être organisées en V ou selon toute autre configuration.

Les racles peuvent être réalisées dans un matériau de type élastomère ou métallique.

Chaque racle R_i est indépendante du point de vue mécanique ce qui lui permet d'adapter sa pression de raclage. La pression de raclage est définie par la force exercée par la racle R_i contre l'écran 30, suivant une direction normale à l'écran.

Chaque racle R_i est montée sur des moyens de réglage en hauteur commandables, permettant d'ajuster sa hauteur H_i (c'est-à-dire sa course verticale) par rapport à l'écran 30 et au support 1, et donc sa pression mécanique de raclage contre l'écran 30. Ces moyens de réglage en hauteur peuvent être constitués d'un ou plusieurs actionneurs 20 de type vérins hydrauliques ou pneumatiques ou de type moteur électrique (M sur les figures annexées).

Sur les figures 3A et 3B, les moyens de réglage en hauteur de toutes les racles R_i sont fixés sur un châssis 21 commun comportant une seule glissière 22. On verra que le dispositif peut comporter des moyens de réglage de l'orientation de la glissière 22 par rapport au support 1, selon l'orientation des lignes conductrices parallèles à réaliser.

Sur la figure 3C, toutes les racles sont indépendantes en hauteur et en course suivant l'axe (X). Une glissière distincte 22_i et un moteur M_i distinct est associé à chaque racle R_i de manière à permettre son contrôle indépendant en pression et en course le long du support 1.

Le dispositif comporte un système de commande des N racles. Le système de commande peut comporter un automate programmable 23 doté de plusieurs entrées/sorties (par exemple réalisées sous la forme de modules I/O). Chaque racle est commandée en pression par l'automate programmable 23 qui exécute un module de commande MOD_i spécifique comportant une boucle de régulation. La commande peut être réalisée en boucle fermée (avec un capteur de mesure de la pression exercée par la racle) ou en boucle ouverte ("sensorless" c'est-à-dire sans capteur mais avec une estimation logicielle de la pression exercée par la racle - par exemple à partir du couple exercé par l'actionneur). Dans un fonctionnement en boucle fermée, pour chaque racle R_i, l'automate programmable 23 reçoit sur une entrée la pression de raclage mesurée pour la racle et exécute le module de commande MOD_i pour déterminer le signal de commande S_i à envoyer sur l'une de ses sorties vers l'actionneur de commande de la racle.

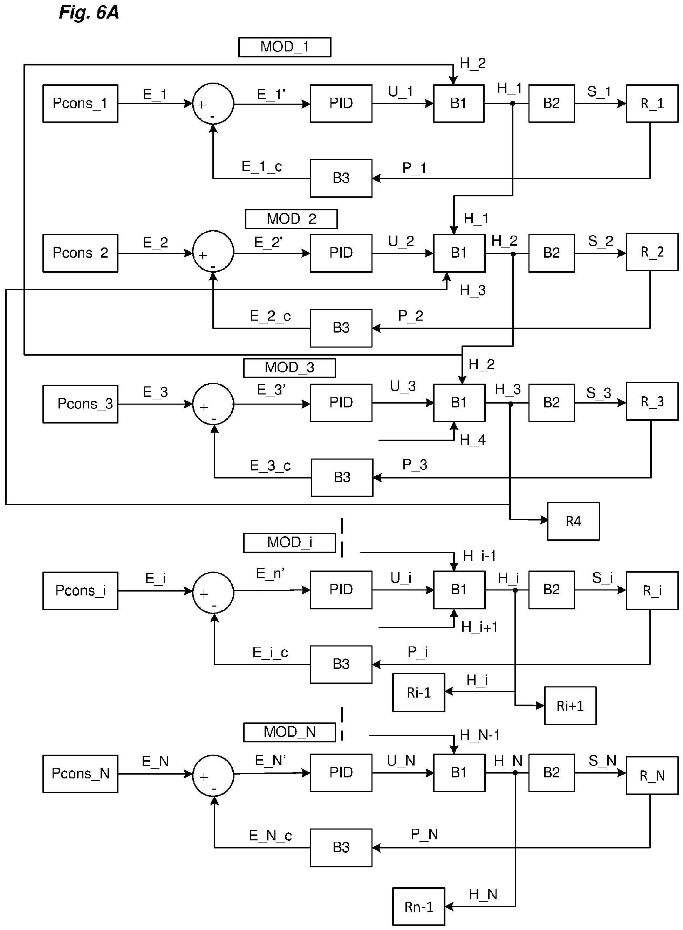

Les figures 6A à 6C représentent plusieurs diagrammes de commande des N racles du dispositif. Chaque diagramme de commande montre les N modules de commande MOD_i exécutés pour la commande de chaque racle R_i.

De manière particulière, les modules de commande sont interdépendants, c'est-à-dire que la commande d'au moins une racle influe sur la commande des autres racles.

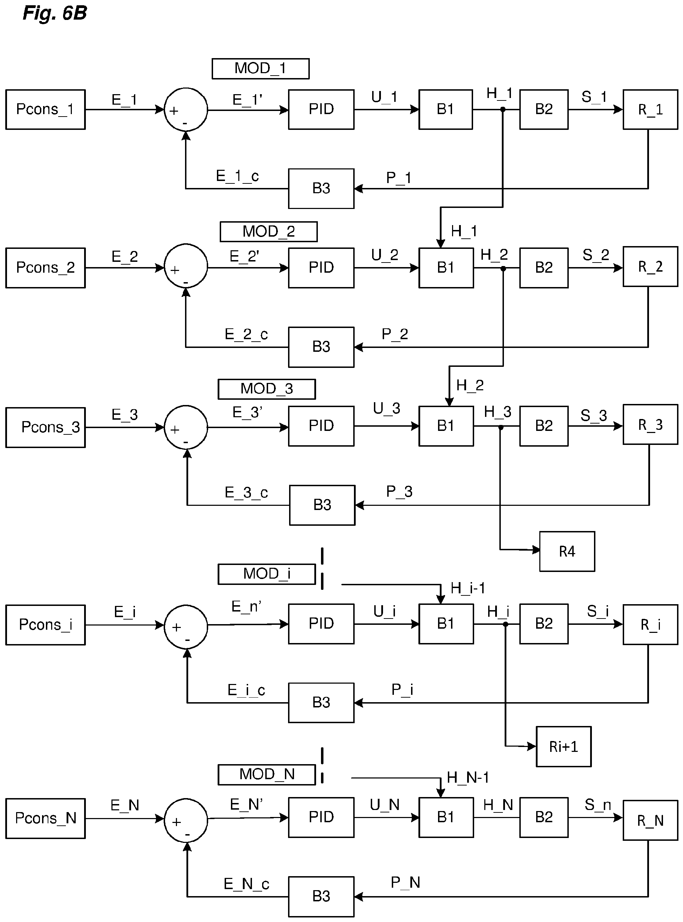

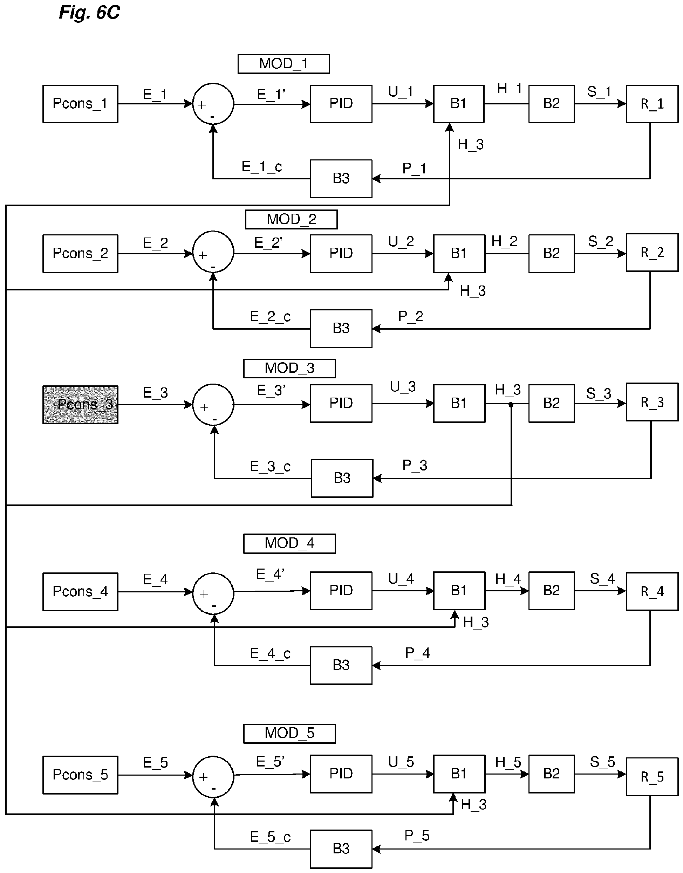

En référence aux figures 6A à 6C, on peut ainsi envisager différents schémas de commande :
- Dans un premier schéma représenté sur la figure 6A, les commandes des racles sont toutes interdépendantes. Le module de commande associé à chaque racle envoie la hauteur H_i de sa racle aux modules de commande des racles qui sont juxtaposées à sa racle. Dans cette configuration, toutes les racles sont à la fois maître et esclave car leur module de commande envoie des données vers un autre module de commande et reçoit des données en provenance d'un ou plusieurs modules de commande (selon sa position dans l'alignement de racles).
- Dans un deuxième schéma représenté sur la figure 6B, la commande est réalisée en cascade. Le module de commande associé à la racle de rang 1 envoie la hauteur de sa racle au module de commande associé à la racle de rang 2 et ainsi de suite jusqu'à la racle de rang N. Bien entendu, ce principe en cascade peut être adapté en définissant un ordre différent entre les racles. La racle ayant le rang 1 peut être considéré comme la racle maître et les autres racles comme des racles esclaves.
- Dans un troisième schéma représenté sur la figure 6C, une racle est désignée comme racle maître (racle R_3 sur la figure 6C) et son module de commande envoie la hauteur de sa racle à tous les autres modules de commande des autres racles, qui sont alors des racles esclaves. Le nombre de racles est préférentiellement impair (par exemple cinq racles sur la figure 6C) et la racle maître est avantageusement la racle qui est située au centre.

De manière plus précise, en référence à la figure 6A, le premier schéma de commande peut présenter les particularités suivantes :
- Chaque module de commande MOD_i reçoit une valeur de consigne en pression Pcons_i en entrée ; la valeur de consigne appliquée peut être identique pour toutes les racles ou particulière à chaque racle selon sa position dans le dispositif ;
- A partir de la valeur de consigne en pression, le module de commande MOD_i génère une valeur d'entrée E_i ;
- Cette valeur d'entrée E_i est comparée avec une première valeur de correction E_i_c déterminée par un bloc B3 à partir de la pression courante P_i mesurée ou estimée de la racle ; Le bloc B3 est configuré pour réaliser une mise en forme du signal de pression P_i mesurée en un signal numérique E_i_c de correction ;
- La différence E'_i entre les deux valeurs est injectée dans un correcteur, par exemple à action PID (Proportionnelle-Intégrale-Dérivée) de manière à déterminer une valeur de commande U_i en hauteur qui devrait être appliquée à la racle en sortie pour obtenir la valeur de consigne appliquée en entrée ;
- La valeur de commande U_i déterminée par le correcteur est corrigée, dans un bloc B1 (bloc addition), d'une deuxième valeur de correction représentative de la hauteur de chaque racle adjacente ; Pour la racle de rang 1, il s'agit donc de la hauteur H_2 de la racle de rang 2 ; Pour la racle de rang N, il s'agit de la hauteur H_N-1 de la racle de rang N-1 ; Pour la racle de rang i, avec i allant de 2 à N-1, il s'agit à la fois de la hauteur H_i-1 de la racle de rang i-1 et de la hauteur H_i+1 de la racle de rang i+1 ;
- A partir de la hauteur H_i à appliquer à la racle, le module de commande MOD_i génère dans un bloc B2 un signal de commande S_i numérique à envoyer à l'actionneur pour répondre à la valeur de consigne appliquée en entrée ; Ce bloc B2 est configuré pour mettre en forme le signal de hauteur H_i obtenu en un signal numérique S_i ;

En référence à la figure 6B, le deuxième schéma de commande présente les particularités suivantes :
- Chaque module de commande MOD_i reçoit une valeur de consigne en pression Pcons_i en entrée ; la valeur de consigne appliquée peut être identique pour toutes les racles ou particulière à chaque racle selon sa position dans le dispositif ;
- A partir de la valeur de consigne en pression Pcons_i, le module de commande MOD_i génère une valeur d'entrée E_i ;
- Cette valeur d'entrée E_i est comparée avec une première valeur de correction E_i_c déterminée par un bloc B3 à partir de la pression courante P_i mesurée ou estimée de la racle ; Le bloc B3 est configuré pour réaliser une mise en forme du signal de pression P_i en un signal numérique E_i_c de correction ;
- La différence E'_i entre les deux valeurs est injectée dans un correcteur, par exemple à action PID (Proportionnelle-Intégrale-Dérivée) de manière à déterminer la valeur de commande U_i qui devrait être appliquée à la racle en sortie pour obtenir la valeur de consigne appliquée en entrée ;
- Le module de commande MOD_i détermine la hauteur à appliquer à la racle dans un bloc B1 (Bloc addition). Pour les racles des rangs 2 à n, ce bloc B1 reçoit la valeur de la hauteur H_i-1 de la racle de rang i-1 ; Seule la commande de la racle de rang 1 n'est pas dépendante des commandes des autres racles ;
- A partir de la hauteur H_i déterminée pour la racle, le module de commande MOD_i détermine dans un bloc B2 le signal de commande S_i à envoyer à l'actionneur pour répondre à la valeur de consigne appliquée en entrée ; Ce bloc B2 est configuré pour mettre en forme le signal de hauteur H_i obtenu en signal numérique S_i ;

En référence à la figure 6C, le troisième schéma de commande présente les particularités suivantes :
- Chaque module de commande MOD_i reçoit une valeur de consigne en pression Pcons_i en entrée ; la valeur de consigne Pcons_i appliquée peut être identique pour toutes les racles ou particulière à chaque racle selon sa position dans le dispositif ;
- A partir de la valeur de consigne en pression Pcons_i, le module de commande MOD_i génère une valeur d'entrée E_i ;
- Cette valeur d'entrée E_i est comparée avec une première valeur de correction E_i_c déterminée par un bloc B3 à partir de la pression courante mesurée ou estimée de la racle ; Le bloc B3 est configuré pour réaliser une mise en forme du signal de pression P_i en un signal numérique E_i_c de correction ;
- La différence E'_i entre les deux valeurs est injectée dans un correcteur, par exemple à action PID (Proportionnelle-Intégrale-Dérivée) de manière à déterminer la valeur de commande U_i qui devrait être appliquée à la racle en sortie pour obtenir la valeur de consigne appliquée en entrée ;
- La racle de rang 3 (dans une solution à cinq racles) est désignée comme la racle maître son module de commande MOD3 impose sa commande (c'est-à-dire sa hauteur H_3) à tous les autres modules de commande associés aux racles esclaves ;
- Pour la racle de rang 3, son module de commande MOD3 détermine directement dans un bloc B1 (bloc addition) la hauteur H_3 à appliquer à sa racle R3 ;
- Pour toutes les autres racles, leur module de commande détermine dans leur bloc B1 (bloc addition) la hauteur à appliquer à leur racle en tenant compte de la hauteur H_3 de la racle maître ;
- A partir de la hauteur H_i déterminée pour la racle, le module de commande MOD_i détermine dans un bloc B2 le signal de commande S_i à envoyer à l'actionneur pour répondre à la valeur de consigne appliquée en entrée ; Ce bloc B2 est configuré pour mettre en forme le signal de hauteur H_i obtenu en signal numérique S_i ;

On comprend de ce qui précède que le signal de commande de chaque racle esclave est déterminé en tenant compte de la position (la hauteur) d'au moins une autre racle. Et selon le schéma envisagé, il pourra être tenu compte de la position d'une racle supplémentaire (cas du premier schéma de commande).

Le système sera plus efficace avec un nombre impair de racles. Dans le cas du troisième schéma de commande, la racle centrale est choisie comme racle "maître" afin de bénéficier d'une régulation plus précise par rapport au centre de l'écran.

Selon une particularité, l'automate programmable 23 peut mettre en œuvre une procédure d'initialisation du dispositif afin de calibrer la pression exercée ou la contre-réaction générée sur une racle maître servant de référence pour les autres racles.

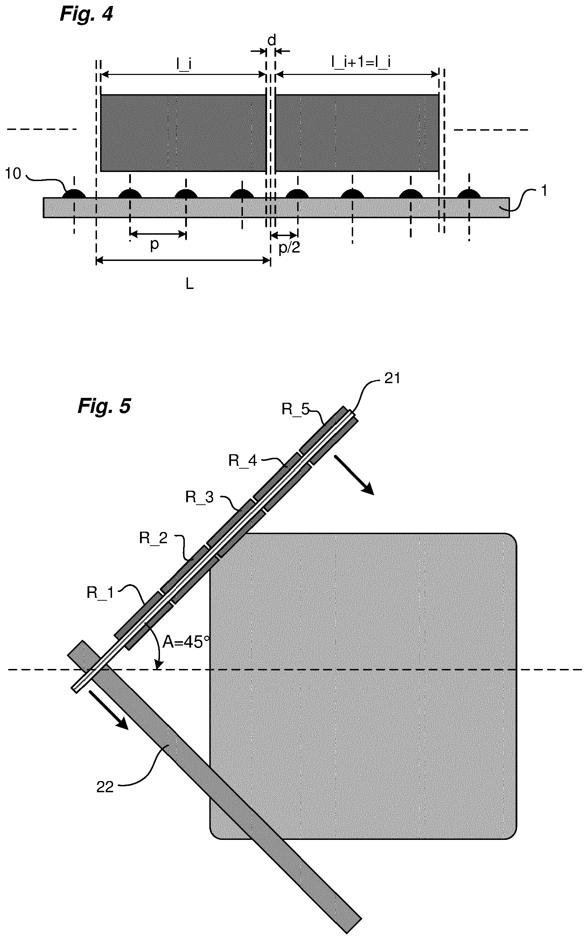

Comme on peut le voir sur la figure 4, pour réaliser des lignes conductrices 10 espacées entre elles d'un pas p donné qui est en règle générale constant, il faut veiller à tenir compte d'au moins deux paramètres, c'est-à-dire la longueur l_i de chaque racle et la distance d'espacement entre deux racles. En considérant que toutes les racles sont d'une longueur l_i identique et qu'elles sont espacées d'une distance constante, la longueur l_i de la racle devra être compatible avec le pas p du motif, c'est-à-dire la distance interlignes. La longueur l_i d'une racle doit vérifier la relation suivante :
L>= l_i >=(p × nₗ)
où :
- L est une longueur maximale valant (p × nₗ)+d,
- nₗ nombre de lignes sous la racle,
- p le pas entre deux lignes conductrices à réaliser,
- d la distance à respecter entre deux racles (distance choisie supérieure ou égale à 0, par exemple comprise entre 0 et 0.2mm).

Par ailleurs, le nombre de racles et la taille de la racle devront être adaptés pour obtenir une longueur de raclage supérieure ou égale à la taille t du support 1. On aura ainsi l'expression suivante de la taille t du support :
t=somme(l_i) + D avec i allant de 1 à N et D compris entre 0 et 20mm.

Partant de là, pour un support de 156x156, on peut avoir les configurations suivantes :
- N=3 racles d'une longueur l_i de 75mm chacune ;
- N=5 racles d'une longueur l_i de 45mm chacune ;
- N=7 racles d'une longueur l_i de 30mm chacune ;

Comme indiqué ci-dessus, il est possible de prévoir des moyens de réglage en rotation du châssis supportant les racles de manière à orienter chaque glissière par rapport au support et ainsi prévoir une impression selon différents angles. La glissière peut ainsi être orientée d'un angle A compris entre 0° et 90°. Le principe sera ainsi de pouvoir sérigraphier des lignes, par exemple à 45° (comme sur la figure 5), tout en conservant la même direction de raclage. La figure 5 illustre ce principe pour le mode de réalisation à une seule glissière 23 et châssis commun.

En permettant de conserver une direction de raclage parallèle aux lignes conductrices à sérigraphier la qualité d'impression sera supérieure et se traduira par l'obtention de lignes à largeurs plus homogènes.

La solution de l'invention présente plusieurs avantages listés ci-dessous :
- Un premier avantage de la commande vise à améliorer la qualité de l'impression par l'emploi de plusieurs racles régulées de manière interdépendante en pression.
- Un second avantage est de répartir les contraintes exercées par les racles sur toute la longueur de l'écran. En contrôlant mieux les contraintes exercées entre les extrémités et au centre de l'écran via la pression de raclage de chaque racle, on peut notamment s'attendre à augmenter la durée de vie des écrans. Par exemple, dans le cas d'un support ("wafer") de taille 156mm×156mm imprimé avec une seule racle de 160 mm on observe une inhomogénéité entre la largeur des lignes sérigraphiées en centre support et celles présentes vers l'extérieur. Avec un dispositif conforme à l'invention, doté de cinq racles identiques ayant une longueur de 45 mm chacune, la contrainte linéique appliquée sera localement plus forte (défini par σ=Force/longueur racle) à force appliquée constante, par rapport à un dispositif doté d'une seule racle de 160 mm. De plus, une racle de plus petite longueur aura une rigidité plus importante. Ainsi grâce au facteur géométrique (longueur) et à la propriété mécanique intrinsèque de la racle, l'inhomogénéité entre les zones situées vers les bords et le centre sera réduite d'un facteur égal au nombre de racles employées dans le dispositif.
- Un troisième avantage réside dans la possibilité de modifier l'asservissement de manière temporaire, pour exercer volontairement une pression très supérieure sur une des racles du dispositif afin de "déboucher localement" une maille obstruée de l'écran. Il arrive en effet fréquemment en sérigraphie de production qu'un écran se bouche à un endroit précis (formation d'un agrégat de pâte de sérigraphie). Dans ces cas-là, une des méthodes pour le déboucher consiste à augmenter la pression (jusqu'à plus de 50%) et à réduire la vitesse de raclage sur quelques supports.
- Un dernier avantage réside dans le contrôle indépendant de la course des racles le long du raclage. Grâce au système de glissière, la course le long de cet axe de chaque racle pourra être contrôlée indépendamment les unes des autres. Néanmoins la vitesse de raclage des racles sera constante.

## Revendications

1. Dispositif de raclage employé pour réaliser par sérigraphie des lignes conductrices parallèles sur un support (1) à travers un masque, le dispositif comportant:
- N racles (R_i), avec N supérieur ou égal à 2, chaque racle étant définie par un rang i, avec i allant de 1 à N, les N racles étant disposées de manière adjacente et déplaçables en translation pour générer chacune de manière distincte, une ou plusieurs desdites lignes parallèles,
- Des moyens de réglage en hauteur associés à chaque racle, ladite hauteur correspondant à la distance entre la racle et ledit support (1) suivant une direction normale audit support à imprimer,
- Un système de commande du dispositif de raclage qui comporte, pour chaque racle de rang i, un module de commande (MOD_i) indépendant configuré pour commander ses moyens de réglage en hauteur,
- Les N racles étant constituées d'une seule racle dite racle maître et de racles dite racles esclaves,
le dispositif étant **caractérisé en ce que**:
- Chaque module de commande est configuré pour déterminer un signal de commande à destination desdits moyens de réglage en hauteur, ledit signal de commande étant généré à partir d'une boucle de régulation sur une valeur de consigne appliquée en entrée, et, pour chaque racle esclave, d'une valeur de contre-réaction provenant du module de commande dédiée à la commande d'au moins une autre racle.

2. Dispositif selon la revendication 1, **caractérisé en ce que** le module de commande (MOD_i) associé à chaque racle reçoit la valeur de contre-réaction provenant du module de commande associé à chaque racle qui est juxtaposée à sa racle.

3. Dispositif selon la revendication 1, **caractérisé en ce que** le module de commande associé à chaque racle de rang i, pour i allant de 2 à N, reçoit la valeur de contre-réaction provenant du module de commande de chaque racle de rang i-1.

4. Dispositif selon la revendication 1, **caractérisé en ce que** le module de commande associé à chaque racle esclave reçoit la valeur de contre-réaction provenant du module de commande de la racle maître.

5. Dispositif selon l'une des revendications 1 à 4, **caractérisé en ce que** la valeur de consigne est une valeur de pression mécanique (Pcons_i) de raclage.

6. Dispositif selon la revendication 5, **caractérisé en ce que** la valeur de consigne en pression est identique pour toutes les racles.

7. Dispositif selon l'une des revendications 1 à 6, **caractérisé en ce que** chaque valeur de contre-réaction est une hauteur de racle.

8. Dispositif selon l'une des revendications 1 à 7, **caractérisé en ce que** les moyens de réglage en hauteur (20) associés à chaque racle sont tous montés sur un châssis (21) commun.

9. Dispositif selon la revendication 8, **caractérisé en ce que** le châssis comporte une glissière (22) orientée suivant la direction de raclage à appliquer.

10. Dispositif selon l'une des revendications 1 à 7, **caractérisé en ce que** les moyens de réglage en hauteur (20) associés à chaque racle sont tous montés sur un châssis indépendant par rapport à celui de chaque autre racle, chaque châssis indépendant comprenant une glissière (22_i) indépendante pour guider la course de sa racle.

11. Dispositif selon la revendication 9 ou 10, **caractérisé en ce qu'**il comporte des moyens de réglage de l'orientation de chaque glissière pour adapter l'angle (A) de raclage.

12. Procédé de réalisation de lignes conductrices parallèles sur un support (1) par sérigraphie à travers un masque, mis en œuvre à l'aide d'un dispositif de raclage tel que défini dans l'une des revendications 1 à 11, où pour chaque racle esclave du dispositif, il comporte les étapes suivantes :
- Détermination d'une valeur de commande (U_i) à partir d'une valeur de consigne et d'une première valeur corrigée représentative d'une pression mesurée ou estimée de la racle esclave,
- Détermination de la hauteur (H_i) de la racle esclave en fonction de ladite valeur de commande (U_i) et d'une valeur de contre-réaction provenant du module de commande dédiée à la commande d'au moins une autre racle du dispositif.

13. Procédé selon la revendication 12, **caractérisé en ce que** le module de commande (MOD_i) associé à chaque racle reçoit la valeur de contre-réaction provenant du module de commande associé à chaque racle qui est juxtaposée à sa racle.

14. Procédé selon la revendication 12, **caractérisé en ce que** le module de commande associé à chaque racle de rang i, pour i allant de 2 à N, reçoit la valeur de contre-réaction provenant du module de commande de chaque racle de rang i-1.

15. Procédé selon la revendication 12, **caractérisé en ce que** le module de commande associé à chaque racle esclave reçoit la valeur de contre-réaction provenant du module de commande de la racle maître.

16. Utilisation du dispositif de raclage défini dans l'une des revendications 1 à 11 pour réaliser des lignes conductrices (10) parallèles sur un support (1) d'une cellule photovoltaïque.

## Patentansprüche

1. Rakelvorrichtung zur Herstellung der parallelen Leiterbahnen auf einem Träger (1) durch eine Maske mittels Siebdruck, wobei die Vorrichtung Folgendes aufweist:
- N Rakel (R_i), wobei N größer oder gleich 2 ist, wobei jede Rakel durch einen Rang i definiert ist, wobei i von 1 bis N geht, wobei die N Rakel benachbart und translatorisch verschiebbar angeordnet sind, um jeweils eine oder mehrere der parallelen Leiterbahnen gesondert zu erzeugen,
- Höhenverstellmittel, die jeder Rakel zugeordnet sind, wobei die Höhe dem Abstand zwischen der Rakel und dem Träger (1) in einer Richtung entspricht, die normal zum zu bedruckenden Träger verläuft,
- ein Steuersystem der Rakelvorrichtung, das für jede Rakel von Rang i ein unabhängiges Steuermodul (MOD_i) aufweist, das dazu ausgebildet ist, deren Höhenverstellmittel zu steuern,
- wobei die N Rakel von einer einzelnen Master-Rakel und von Slave-Rakeln gebildet sind,
wobei die Vorrichtung **dadurch gekennzeichnet ist, dass**:
- jedes Steuermodul dazu ausgebildet ist, ein Steuersignal zu bestimmen, das für die Höhenverstellmittel bestimmt ist, wobei das Steuersignal ausgehend von einer Regelschleife anhand eines Vorgabewerts, der am Eingang angelegt ist, und für jede Slave-Rakel, von einem Gegenreaktionswert aus dem Steuermodul, der für die Steuerung mindestens einer anderen Rakel vorgesehen ist, erzeugt wird.

2. Vorrichtung nach Anspruch 1, **dadurch gekennzeichnet, dass** das Steuermodul (MOD_i), das jeder Rakel zugeordnet ist, den Gegenreaktionswert aus dem Steuermodul empfängt, das jeder Rakel zugeordnet ist, das neben seiner Rakel angeordnet ist.

3. Vorrichtung nach Anspruch 1, **dadurch gekennzeichnet, dass** das Steuermodul, das jeder Rakel von Rang i zugeordnet ist, wobei i von 2 bis N geht, den Gegenreaktionswert aus dem Steuermodul jeder Rakel von Rang i-1 empfängt.

4. Vorrichtung nach Anspruch 1, **dadurch gekennzeichnet, dass** das Steuermodul, das jeder Slave-Rakel zugeordnet ist, den Gegenreaktionswert aus dem Steuermodul der Master-Rakel empfängt.

5. Vorrichtung nach einem der Ansprüche 1 bis 4, **dadurch gekennzeichnet, dass** der Vorgabewert ein mechanischer Rakeldruckwert (Pcons_i) ist.

6. Vorrichtung nach Anspruch 5, **dadurch gekennzeichnet, dass** der Druckvorgabewert für alle Rakel identisch ist.

7. Vorrichtung nach einem der Ansprüche 1 bis 6, **dadurch gekennzeichnet, dass** jeder Gegenreaktionswert eine Rakelhöhe ist.

8. Vorrichtung nach einem der Ansprüche 1 bis 7, **dadurch gekennzeichnet, dass** die Höhenverstellmittel (20), die jeder Rakel zugeordnet sind, alle auf einem gemeinsamen Gestell (21) angebracht sind.

9. Vorrichtung nach Anspruch 8, **dadurch gekennzeichnet, dass** das Gestell eine Gleitführung (22) aufweist, die gemäß der anzuwendenden Rakelrichtung orientiert ist.

10. Vorrichtung nach einem der Ansprüche 1 bis 7, **dadurch gekennzeichnet, dass** die Höhenverstellmittel (20), die jeder Rakel zugeordnet sind, alle auf einem Gestell angebracht sind, das bezogen auf das jeder anderen Rakel unabhängig ist, wobei jedes unabhängige Gestell eine unabhängige Gleitführung (22_i) aufweist, um den Weg seiner Rakel zu führen.

11. Vorrichtung nach Anspruch 9 oder 10, **dadurch gekennzeichnet, dass** sie Mittel zur Einstellung der Orientierung jeder Gleitführung aufweist, um den Rakelwinkel (A) anzupassen.

12. Verfahren zur Herstellung paralleler Leiterbahnen auf einem Träger (1) mittels Siebdruck durch eine Maske, das mithilfe einer Rakelvorrichtung nach einem der Ansprüche 1 bis 11 durchgeführt wird, wobei es für jede Slave-Rakel der Vorrichtung die folgenden Schritte aufweist:
- Bestimmen eines Steuerwerts (U_i) anhand eines Vorgabewerts und eines ersten korrigierten Werts, der für einen gemessenen oder geschätzten Druck der Slave-Rakel repräsentativ ist,
- Bestimmen der Höhe (H_i) der Slave-Rakel je nach dem Steuerwert (U_i) und einem Gegenreaktionswert aus dem Steuermodul, der zur Steuerung mindestens einer anderen Rakel der Vorrichtung vorgesehen ist.

13. Verfahren nach Anspruch 12, **dadurch gekennzeichnet, dass** das Steuermodul (MOD_i), das jeder Rakel zugeordnet ist, den Gegenreaktionswert aus dem Steuermodul empfängt, das jeder Rakel zugeordnet ist, das neben seiner Rakel angeordnet ist.

14. Verfahren nach Anspruch 12, **dadurch gekennzeichnet, dass** das Steuermodul, das jeder Rakel von Rang i zugeordnet ist, wobei i von 2 bis N geht, den Gegenreaktionswert aus dem Steuermodul jeder Rakel von Rang i-1 empfängt.

15. Verfahren nach Anspruch 12, **dadurch gekennzeichnet, dass** das Steuermodul, das jeder Slave-Rakel zugeordnet ist, den Gegenreaktionswert aus dem Steuermodul der Master-Rakel empfängt.

16. Nutzung der Rakelvorrichtung nach einem der Ansprüche 1 bis 11 zur Herstellung der parallelen Leiterbahnen (10) auf einem Träger (1) einer Photovoltaikzelle.

## Claims

1. Squeegee device used to produce, by screen-printing, parallel conductive lines on a support (1) through a mask, the device comprising:
- N squeegees (R_i), with N greater than or equal to 2, each squeegee being defined by a rank i, with i ranging from 1 to N, the N squeegees being disposed adjacent and able to move in translation in order to each distinctly generate one or more of said parallel lines,
- height setting means associated with each squeegee, each height corresponding to the distance between the squeegee and said support (1) in a direction normal to said support to be printed,
- a control system of the setting device which comprises, for each squeegee of rank i, an independent control module (MOD_i) configured to control its height setting means,
- the N squeegees consisting of a single squeegee, called master squeegee, and squeegees called slave squeegees,
the device being **characterized in that**:
- each control module is configured to determine a control signal intended for said height setting means, said control signal being generated from a regulation loop on a setpoint value applied as input, and, for each slave squeegee, from a feedback value originating from the control module dedicated to the control of at least one other squeegee.

2. Device according to Claim 1, **characterized in that** the control module (MOD_i) associated with each squeegee receives the feedback value originating from the control module associated with each squeegee which is juxtaposed to its squeegee.

3. Device according to Claim 1, **characterized in that** the control module associated with each squeegee of rank i, for i ranging from 2 to N, receives the feedback value originating from the control module of each squeegee of rank i-1.

4. Device according to Claim 1, **characterized in that** the control module associated with each slave squeegee receives the feedback value originating from the control module of the master squeegee.

5. Device according to one of Claims 1 to 4, **characterized in that** the setpoint value is a scraping mechanical pressure value (Pcons_i).

6. Device according to Claim 5, **characterized in that** the pressure setpoint value is identical for all the squeegees.

7. Device according to one of Claims 1 to 6, **characterized in that** each feedback value is a squeegee height.

8. Device according to one of Claims 1 to 7, **characterized in that** the height setting means (20) associated with each squeegee are all mounted on a common frame (21).

9. Device according to Claim 8, **characterized in that** the frame comprises a runner (22) oriented in the scraping direction to be applied.

10. Device according to one of Claims 1 to 7, **characterized in that** the height setting means (20) associated with each squeegee are all mounted on a frame that is independent with respect to that of each other squeegee, each independent frame comprising an independent runner (22_i) for guiding the travel of its squeegee.

11. Device according to Claim 9 or 10, **characterized in that** it comprises means for setting the orientation of each runner to adapt the scraping angle (A).

12. Method for producing parallel conductive lines on a support (1) by screen printing through a mask, implemented using a squeegee device as defined in one of Claims 1 to 11, in which for each slave squeegee of the device, it comprises the following steps:
- determination of a control value (U_i) from a setpoint value and of a first corrected value representative of a measured or estimated pressure of the slave squeegee,
- determination of the height (H_i) of the slave squeegee as a function of said control value (U_i) and of a feedback value originating from the control module dedicated to the control of at least one other squeegee of the device.

13. Method according to Claim 12, **characterized in that** the control module (MOD_i) associated with each squeegee receives the feedback value originating from the control module associated with each squeegee which is juxtaposed to its squeegee.

14. Method according to Claim 12, **characterized in that** the control module associated with each squeegee of rank i, for i ranging from 2 to N, receives the feedback value originating from the control module of each squeegee of rank i-1.

15. Method according to Claim 12, **characterized in that** the control module associated with each slave squeegee receives the feedback value originating from the control module of the master squeegee.

16. Use of the squeegee device defined in one of Claims 1 to 11 to produce parallel conductive lines (10) on a support (1) of a photovoltaic cell.
